# FASCICULE DE BREVET EUROPEEN

(11) **EP 0 369 856 B1**
(45) Date de publication et mention de la délivrance du brevet: **31.05.1995**
(21) Numéro de dépôt: 89403071.7
(22) Date de dépôt: 08.11.1989
(51) Int. Cl.: H01S 3/25, H01S 3/085, H01S 3/094, H01L 33/00

(54) **Dispositif optoélectronique de puissance, et son procédé de réalisation**
Optoelektronische Vorrichtung mit hoher Ausgangsleistung und deren Herstellungsverfahren
Optoelectronic device with a high output, and its production method

(30) Priorité: 15.11.1988 FR 8814799
(43) Date de publication de la demande: 23.05.1990
(73) Titulaire: THOMSON-CSF SEMICONDUCTEURS SPECIFIQUES, 92800 Puteaux (FR)
(72) Inventeur: Mesquida, Guy, F-92402 Courbevoie Cédex (FR); Groussin, Bernard, F-92402 Courbevoie Cédex (FR)
(74) Mandataire: Guérin, Michel

(56) Documents cités:
- DE-A- 2 448 323
- APPLIED PHYSICS LETTERS, vol. 53, no. 11, 12 septembre 1988, pages 938-940, New York, US; J.P. DONNELLY et al.: "Hybrid approach to two-dimensional surface-emitting diode laser arrays"
- APPLIED PHYSICS LETTERS, vol. 51, no. 15, 12 octobre 1987, pages 1138-1140, New York, US; J.P. DONNELLY et al.: "Monolithic two-dimensional surface-emitting arrays of GaAs/AlGaAs diode letters"
- OPTICS LETTERS, vol. 13, no. 3, mars 1988, pages 204-206, New York, US; M.K. REED et al.: "Diode-laser-array-pumped neodymium slab oscillators"
- PATENT ABSTRACTS OF JAPAN, vol. 9, no. 197 (E-335)[1920], 14 août 1985; & JP-A-60 64 487
- APPLIED PHYSICS LETTERS, vol. 40, no. 4, février 1982, pages 289-290, New York, US; H. BLAUVELT et al.: AlGaAs lasers with micro-cleaved mirrors suitable formonolithic integration"

## Description

La présente invention concerne un dispositif optoélectronique de puissance, dont la partie active est constituée par un circuit intégré regroupant une pluralité de lasers semiconducteurs. Par analogie avec les circuits intégrés dits "mer de portes", le circuit intégré selon l'invention pourrait être appelé "mer de lasers". L'invention concerne également le procédé de fabrication de ce circuit intégré de lasers.

Les lasers semiconducteurs en éléments discrets ou en barreaux associant plusieurs lasers élémentaires sont bien connus, mais ils ne fournissent qu'une faible énergie par rapport aux lasers à gaz ou à excimères par exemple. Ils conviennent pour la lecture d'informations dans les mémoires optiques, ou en association avec des fibres optiques en télécommunications, mais ne sont plus suffisants pour des applications nécessitant une forte puissance, telles que la découpe ou la soudure industrielles, ou les applications médicales.

Pour de telles applications, on utilise soit des lasers à gaz, soit des lasers solides.

On appelle lasers solides, par opposition aux lasers semiconducteurs qui sont aussi à l'état solide, des barreaux de section ronde ou carrée, d'environ 5 cm x 5 mm, en matériaux tels que les YAG (Yttrium-aluminium-grenat), les YLF (yttrium-lithium-fluorure) ou le niobiate de lithium Li Nb O₃, tous dopés au néodyme, par exemple. Ces barreaux émettent une lumière cohérente dans les fenêtres centrées sur 1,06, 1,55 ou 2,1 um, respectivement, lorsqu'ils sont excités par une lampe flash au xénon, alimentée sous 1,5 kV et plusieurs dizaines d'ampères, avec un rendement de 0,01 %.

Non seulement ce rendement est très mauvais, mais encore les lampes au xénon, très côuteuses, ne durent qu'environ 100 heures, et leur alimentation est également très côuteuse, et volumineuse.

Il serait donc intéressant de remplacer la lampe flash qui excite un laser solide par un dispositif semiconducteur de puissance qui émette une lumière cohérente.

Le document Applied Physics Letters, vol. 51, no. 15, 12 octobre 1987, pages 1138-1140 décrit un dispositif optoélectronique de puissance monolithique constitué par au moins une barrette de lasers et au moins une réglette réflectrice, parallèle à la barrette et réfléchissant la lumière perpendiculairement au plan du substrat.

L'invention propose un circuit intégré regroupant une pluralité de lasers élémentaires, associés, sur la pastille de matériau semiconducteur, en barrettes parallèles entre elles. Ces barrettes sont en relief par rapport à la surface du substrat, de telle sorte qu'elles comportent deux faces clivées, nécessaires au fonctionnement de chaque laser élémentaire. Etant donné qu'un laser émet dans l'axe de sa cavité de Fabry-Perrot, deux rayons lumineux sont émis, pour chaque laser élémentaire, à travers les faces clivées, parallèlement à la surface du substrat. Des jeux de miroirs, disposés entre les barrettes de lasers, réfléchissent à 90° les faisceaux lumineux, et les renvoient perpendiculairement à la surface du substrat. Lesdits miroirs sont formés par usinage du substrat, soit en plans inclinés à 45 °, soit en demi-cylindres, et ils sont recouverts d'au moins une couche métallique qui sert à la fois de réflecteur optique et de conducteur électrique. Une première métallisation de prise de contact est déposée sur chaque barrette de lasers, et une deuxième métallisation de prise de contact est déposée sur chaque réflecteur. Au sein d'une barrette, les lasers élémentaires sont alimentés en parallèles, entre ces deux dites métallisations, et les barrettes sont préférablement alimentées en série, entre elles, ce qui simplifie l'alimentation générale du circuit intégré de lasers : une alimentation de 60 V sous 16 A est plus fiable qu'une alimentation de 2V sous 500 A.

De façon plus précise, un premier aspect de l'invention est un dispositif optoélectronique de puissance selon la revendication 1.

Un second aspect de l'invention est un dispositif optoélectronique de puissance selon la revendication 7. Un dernier aspect de l'invention est un procédé de réalisation d'un dispositif optoélectronique de puissance selon la revendication 8.

L'invention sera mieux comprise au moyen de la description plus détaillée, qui suit, d'un exemple de réalisation, cette description s'appuyant sur les figures jointes en annexes, qui représentent :
- fig. 1 : schéma structurel d'un laser semiconducteur, selon l'art connu,
- fig. 2 : courbe de réponse en puissance en fonction de l'intensité d'excitation d'un laser,
- fig. 3 : schéma d'excitation d'un laser solide en barreau par une pluralité de lasers semiconducteurs,
- fig. 4 : coupe d'une barrette de lasers semiconducteurs, en éléments discrets, selon l'art connu,
- fig. 5 : vue de 3/4 dans l'espace d'un montage associant une pluralité de circuits intégrés de lasers, selon l'invention, avec un laser solide en plaque,
- fig. 6 : vue dans l'espace d'un circuit intégré de lasers, selon l'invention,
- fig. 7 et 8 : deux vues en coupe du substrat semiconducteur de départ, montrant la réalisation des miroirs de renvoi des faisceaux lumineux, selon l'invention,
- fig. 9 : schéma structurel des couches de matériaux semiconducteurs d'un laser élémentaire, selon l'invention,
- fig. 10 et 11 : deux étapes de fabrication des faces clivées des barrettes de lasers, selon l'invention,
- fig. 12 : étape finale de fabrication des faces clivées des barrettes de lasers, selon l'invention,
- fig. 13 : vue de 3/4 dans l'espace d'une face latérale de barrette, selon l'invention,
- fig. 14 : schéma en plan des métallisations d'alimentation électrique des lasers d'un circuit intégré selon l'invention.

Le rappel préliminaire de la structure et des conditions de fonctionnement d'un laser semiconducteur, ainsi que des conditions à réaliser pour obtenir un laser de puissance permettront de mieux comprendre l'invention et ses avantages.

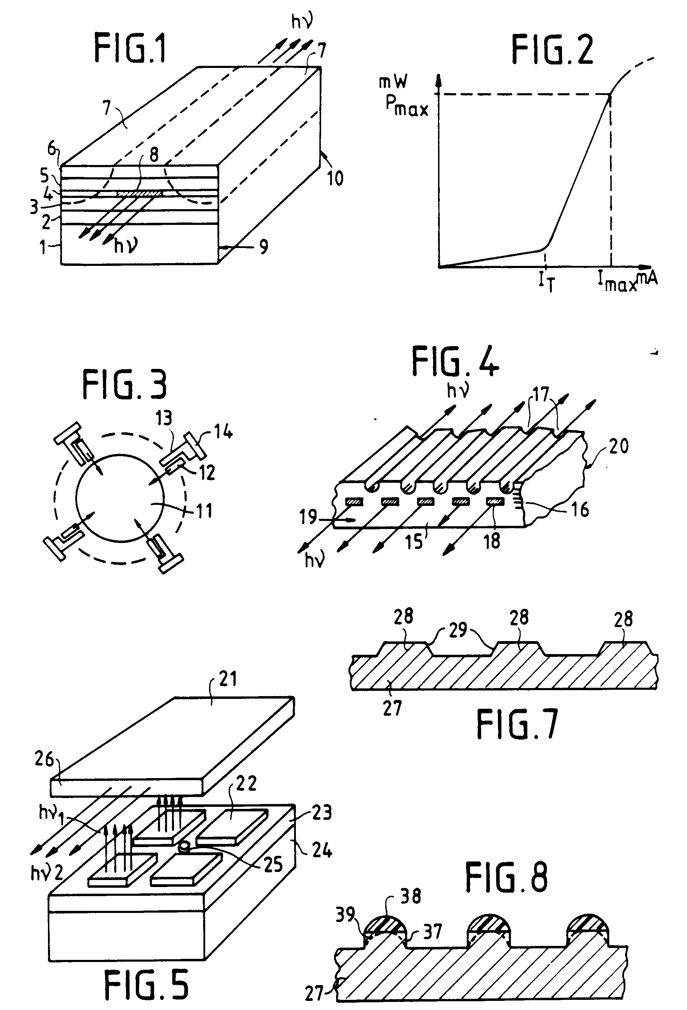

Un laser élémentaire semiconducteur, représenté en figure 1, comprend essentiellement, supportées par un substrat 1 conducteur, en GaAs n par exemple :
- une couche de lissage 2, d'adaptation de paramètres de mailles cristallines,
- une couche de confinement 3, en GaAlAs n
- une couche active 4, en GaAlAs n
- une couche de confinement 5, en GaAlAs p
- une couche de prise de contact 6, en GaAs p.

Divers moyens, schématiquement représentés en 7, permettent de guider le courant électrique, qui traverse les couches perpendiculairement, pour que seul un ruban 8 dans la couche active 4 forme, avec les deux faces clivées 9 et 10 qui terminent ce ruban 8, une cavité de Fabry-Perrot. Un tel laser émet un faisceau de lumière cohérente, dans le plan du ruban 8, par ses deux faces clivées 9 et 10. Si un laser est intégré dans un circuit intégré, il émet parallèlement au substrat, et non pas perpendiculairement comme les diodes électroluminescentes qui n'ont pas de faces clivées pour former une cavité.

Les moyens 7 de guidage peuvent être, entre autres :
- soit deux caissons implantés, à très forte résistance : le laser est alors guidé par le gain
- soit deux sillons gravés parallèles au ruban 8 : le laser est dit à guidage par l'indice.

Dans tous les cas, la courbe de réponse d'un laser semiconducteur en fonction de l'intensité d'excitation est de la forme représentée en figure 2. Pour une intensité inférieure au courant de seuil I_{T}, le laser émet très faiblement : toute l'énergie est transformée en chaleur. Au delà du courant de seuil, il y a émission lumineuse, jusqu'à une puissance maximale au delà de laquelle les effets ne sont plus linéaires, et il peut y avoir destruction du laser. Les lasers à structure à puits quantiques sont intéressants parce qu'ils permettent de diminuer le courant de seuil.

Un laser à guidage par le gain, monoruban, émet 10 mW de puissance lumineuse, et a un courant de seuil de 40 mA, tandis qu'un laser à guidage par l'indice, monoruban, émet 40 mW de puissance, pour un courant de seuil de 10 mA. Ce sont donc les lasers à guidage par l'indice, sur couches à puits quantique, qui sont choisis pour réaliser l'invention.

Par ailleurs si l'on groupe plusieurs rubans élémentaires sur une puce, de 300 x 300 »m environ, on sait obtenir 200 mW pour un courant de 500 mA (courant de seuil 250 mA) avec les lasers à guidage par le gain, et 200 mW pour un courant de 300 mA(courant de seuil 100 mA) avec les lasers à guidage par l'indice. Ce qui est d'autant plus intéressant que, dans le cas d'une barrette de lasers guidés par le gain, les faisceaux émis sont couplés entre eux, tandis que dans le cas d'une barrette de lasers guidés par l'indice, les faisceaux ne sont pas couplés : on peut donc éloigner les rubans émissifs pour répartir les calories dégagées en fonctionnement le long de la barrette.

Cependant, l'application directe de ces barrettes de lasers à l'excitation d'un laser solide à YAG par exemple n'est pas possible.

En effet, un barreau de YAG a des raies d'absorption comprises, par exemple, entre 0,78 et 0,82 »m : il sert de transformateur de longeurs d'ondes, et réemet à 1,06 »m (1,55 »m pour le YLF, 2,1 »m pour le Li Nb O₃). Mais la longueur d'onde émise par un laser semiconducteur varie avec la température : il faut donc centrer la raie d'émission du laser semiconducteur sur la raie d'absorption du YAG, ce qui se fait au moyen d'un élément Peltier, volumineux.

De plus, un barreau de YAG a au moins une face recouverte par une couche déposée, qui fait obturateur électronique, connu sous l'appellation Q-Switch. L'énergie émise par les lasers semiconducteurs s'accumule dans le barreau de YAG et, par pompage optique, est libérée, pendant quelques dizaines de nanosecondes, lorsque l'obturateur électronique s'ouvre.

Par conséquent, pour obtenir une grande puissance d'excitation du barreau de YAG par des lasers semiconducteurs, il faut regrouper un grand nombre de barrettes autour de ce barreau.

La figure 3 montre que ce n'est pas technologiquement réalisable. Soit 11 le barreau de YAG, de 5 mm de diamètre, sur 5 cm de longueur ; une barrette 12 de lasers est fixée par une embase 13 de cuivre sur un élément Peltier 14. Le long d'une génératrice du barreau, on peut disposer environ 30 barrettes, soit 300 lasers élémentaires : il est difficile de regrouper plus de 4 ensembles autour d'un barreau de YAG.

Le fondement de l'invention est d'associer les lasers semiconducteurs, regroupés en barrettes sur un circuit intégré, à un laser solide en plaque, excité, sur au moins une face, par un petit nombre de circuits intégrés dont chacun émet une puissance suffisante pour exciter le laser solide.

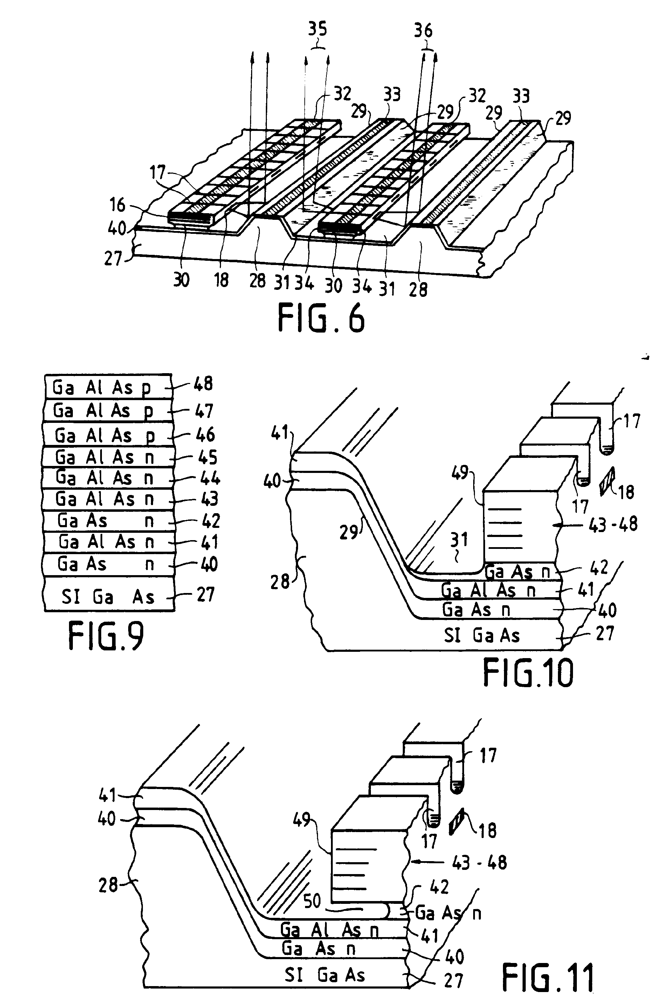

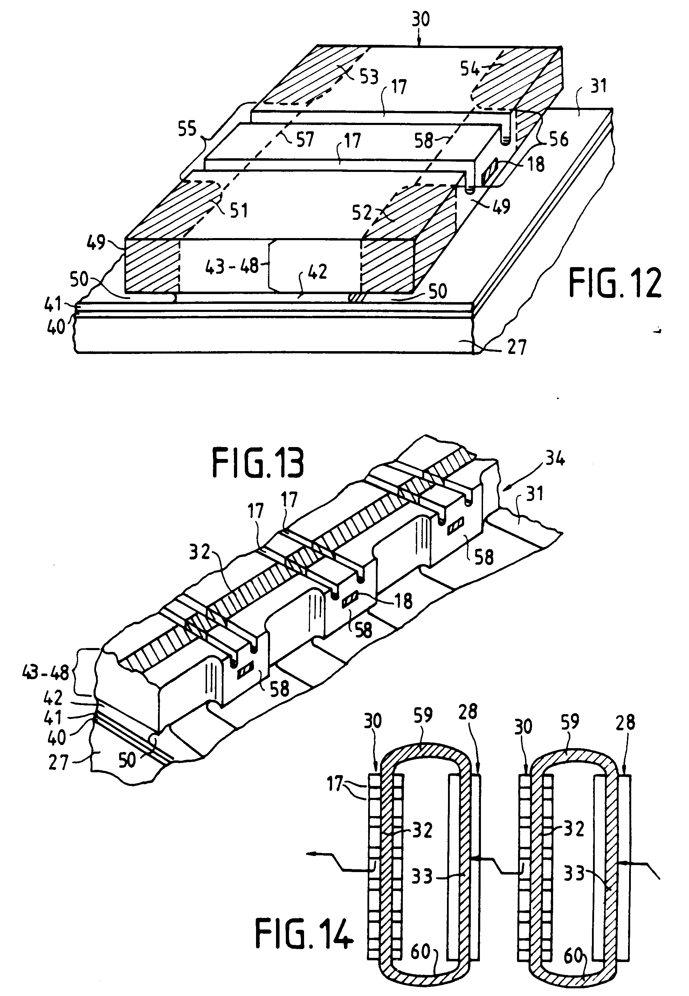

La figure 4 représente un composant de base du circuit intégré selon l'invention. Il s'agit d'une barrette 15 de matériau semiconducteur, dont les diffférentes couches constitutives, détaillées en figure 9, sont seulement évoquées en 16. Des sillons 17, perpendiculaires aux grands côtés de cette barrette, définissent des rubans émetteurs 18. Cette barrette a deux faces clivées 19 et 20, qui sont représentées plus en détail en figure 13.

De telles barrettes existent en éléments discrets, mais elles sont limitées à un petit nombre (10) de lasers élémentaires. En effet, il est nécessaire de cliver deux faces pour que les lasers fonctionnent, et il n'est pas possible de cliver, sans casser les deux faces longitudinales d'une barrette qui serait trop longue par rapport à sa largeur. C'est pourquoi on fait des barrettes de 10 lasers, qui ont des dimensions de 300 x 300 »m, par exemple.

Au contraire, si ces barrettes sont intégrées sur un substrat de circuit intégré, et clivées selon le procédé qui sera décrit plus loin, elles peuvent être plus longues, sans risque de casse, et regrouper un grand nombre de lasers élémentaires. Mais les faisceaux émis, parallèles au substrat doivent être réfléchis pour être utilisables.

Au moins un circuit intégré selon l'invention, réunissant une pluralité de barrettes de lasers semiconducteurs, est associé sur au moins une face principale d'un laser solide YAG en plaque, et non plus en barreau. La figure 5 représente une telle association.

Le laser solide qui doit être excité par les lasers semiconducteurs se présente sous forme d'une plaque 21, de dimensions 5 x 5 cm sur 5 mm d'épaisseur, par exemple. Cette plaque est en YAG, YLF ou Li Nb O₃, ou en d'autres matériaux jouissant des mêmes propriétés.

En regard d'une face principale de la plaque 21 est disposé au moins un circuit intégré 22 de lasers semiconducteurs - il y en quatre sur la figure -, fixé sur la première face d'une embase 23 en métal, en cuivre par exemple, qui sert de répartiteur thermique. Un élément à effet Peltier 24, fixé sur la seconde face de l'embase 23, régule la température du ou des circuits intégrés 22. Une diode réceptrice 25, placée sur l'embase 23, mesure la lumière reçue par la plaque 21, et régule le courant d'alimentation du ou des circuits intégrés 22.

Chaque circuit intégré émet, perpendiculairement à son susbstrat, deux fois plus de faisceaux lumineux qu'il ne comporte de lasers semiconducteurs élémentaires car chaque laser élémentaire émet par ses deux faces clivées avant et arrière. Ces faisceaux excitent la plaque 21, qui les absorbe entre 0,78 et 0,82 »m, et réémet un faisceau cohérent , à 1,06 »m si elle est en YAG, par sa face latérale 26 qui est celle qui supporte l'obturateur électronique. Les autres faces latérales peuvent être rendues réfléchissantes pour n'avoir qu'un seul faisceau de sortie.

Sur la figure 5, la plaque 21 est écartée pour laisser voir l'organisation du ou des circuits intégrés 22. Bien entendu, un second dispositif analogue comprenant au moins un circuit intégré de lasers semiconducteurs, peut être appliqué contre la seconde face principale de la plaque 21 de laser solide. Il suffit de 8 à 10 circuits intégrés 22 pour produire l'excitation qui permet au laser solide d'émettre une impulsion pendant quelques nanosecondes.

La figure 6 montre un fragment de circuit intégré de lasers, selon l'invention. Elle est elle même simplifiée pour la rendre lisible, et les détails de sa constitution sont donnés dans les figures suivantes.

Un circuit intégré selon l'invention comporte un substrat 27 en matériaux de la famille III-V : pour simplifier l'exposé, on admettra que le substrat est en GaAs semi-isolant. Dans ce substrat 27 sont taillés des réflecteurs 28, qui se présentent comme des réglettes parallèles entre elles, de section trapézoïdale, avec des côtés inclinés à 45°, ou de section semi-circulaire. Au moins les flancs 29 de ces réglettes sont métallisés, à la fois pour en faire des miroirs plans inclinés à 45° ou semi-cylindriques, et pour conduire le courant.

Entre les réglettes réflectrices sont disposées les barrettes 30 de lasers semiconducteurs. Chaque barrette comprend, réalisées par une suite d'épitaxies, une pluralité de couches de matériaux semiconducteurs, repérées en 16 et détaillées en figure 9. Dans ces couches sont gravés par usinage ionique une pluralité de sillons 17, parallèles entre eux mais perpendiculaires à l'axe longitudinal de chaque barrette 30 : pris deux par deux, ces sillons 17 définissent les rubans émetteurs 18 de chaque laser élémentaire.

De la série de couches épitaxiées 16, au moins la première couche 40 déposée, dopée donc conductrice, recouvre le substrat semi-isolant 27, sur sa surface libre 31 et sur les flancs 29 des réglettes 28 de réflecteurs.

Une métallisation 32 court sur la face supérieure, libre, de chaque barrette de lasers 30, et une métallisation 33 court sur la face supérieure de chaque réglette 28 de réflecteurs : ces deux métallisations 32 et 33 permettent, en liaison avec la couche conductrice épitaxiée 40, d'alimenter en courant les lasers élémentaires.

Bien entendu, les lasers peuvent également être alimentés verticalement, à travers un substrat 27 qui serait conducteur : on verra plus loin l'intérêt qu'il y a à ce que le substrat soit semi-isolant.

Les faces latérales longitudinales 34 des barrettes 30 de lasers sont clivées, de façon à ce que les rubans émetteurs 18 soient compris entre deux faces clivées formant cavité de Fabry-Perrot.

Lorsque le circuit intégré est mis sous tension, chaque laser élémentaire émet par son ruban 18 un faisceau de lumière cohérente 35 par une face clivée et un faisceau 36 par l'autre face clivée. Ces deux faisceaux sont réfléchis sensiblement perpendiculairement au plan général du circuit intégré par les flancs métallisés 29 des réglettes 28 de réflecteurs. L'ensemble du circuit intégré émet donc une pluralité de faisceaux 35-36, parallèles entre eux et perpendiculaires au plan du substrat.

La description du procédé de fabrication de ce circuit intégré permettra de donner des détails qu'il n'est pas possible d'inclure dans une figure d'ensemble comme la figure 6.

La réalisation du circuit intégré selon l'invention commence par celle des réglettes 28 de réflecteurs. Ceux-ci peuvent être gravés par usinage ionique, avec une section trapézoïdale, dans un substrat épais 27 en GaAs semi-isolant de préférence, tel que montré en figure 7. Les flancs 29 ce ces réglettes sont inclinés à 45° par rapport au plan général du substrat 27. Le procédé est connu et n'a pas lieu d'être détaillé.

Mais ils peuvent également, comme montré en figure 8, être semi-cylindriques. Le procédé est connu. Dans un substrat 27, on crée des ilôts 37 par gravure chimique. Ces ilôts sont recouverts par une couche de résine de masquage 38, qui est ensuite chauffée : par les forces de tensions internes, la résine prend une forme lenticulaire. Les ilôts 37 sont alors attaqués par gravure ionique : l'attaque est plus forte là où la résine est plus mince, et les ilôts gravés ont une forme sensiblement hémicylindrique 39.

Cette seconde forme de réflecteur peut être avantageuse : si le circuit intégré de lasers est associé à un laser solide YAG, la réflexion des faisceaux lumineux est plus dispersée, et le laser solide est excité sur une plus grande surface plus régulièrement.

Sur le substrat 27 gravé selon l'une des figures 7 ou 8, sont alors épitaxiées les couches représentées en figure 9 :
- 40 : GaAs n, sur 2-5 »m d'épaisseur conductrice,
- 41 : GaAlAs n, à dopage graduel, couche d'arrêt pour la future gravure chimique
- 42 : GaAs n, sur 2 » d'épaisseur, en vue de la sous-gravure,
- 43 : GaAlAs n, première couche de confinement
- 44 : GaAlAs n, à dopage graduel
- 45 : GaAlAs n, puits quantique dans lequel se forme le ruban émissif 18
- 46 : GaAlAs p, à dopage graduel
- 47 : GaAlAs p, seconde couche de confinement
- 48 : GaAlAs p, couche de prise de contact électrique.

Pour toutes les couches concernées la composition n'est pas GaAlAs tel qu'écrit par simplification, mais de la forme Ga₁₋ₓ Alₓ As, et il est bien connu que la composition varie d'une couche à l'autre : la composition exacte de ces couches sort du cadre de l'invention.

Cette structure est voisine d'une structure connue, mais on a introduit une couche 41 en GaAlAs supplémentaire et la couche 48 de prise de contact est en GaAlAs au lieu d'être en GaAs habituellement : la raison en est que GaAlAs n'est pas attaqué par la solution NH₄ OH + H₂ O₂ + H₂ O, utilisée pour la suite du processus.

Puis les sillons 17, qui délimitent chaque ruban émissif 18 par guidage par l'indice, sont gravés dans les couches épitaxiées, à l'emplacement des futures barrettes de lasers 30.

La figure 10 montre l'étape suivante de réalisation. Les couches épitaxiées, 40 à 48 recouvrent l'ensemble du substrat y compris les réflecteurs 28 : il faut donc dégager les réflecteurs et les espaces 31, en vue d'obtenir les barrettes 30 de lasers.

Par usinage ionique, toutes les couches, à l'exception des deux couches 40 et 41 les plus profondes, sont décapéees des réglettes 28 de réflecteurs, de leurs flancs 29 et de l'espace 31 qui sépare une réglette 28 de réflecteurs et une barrette 30 de lasers. Chacune de celles-ci possède deux faces longitudinales 49, perpendiculaires au substrat, mais qui ne sont pas clivées : donc les lasers ne peuvent pas fonctionner.

Pour pouvoir effectuer un microclivage sur ces faces 49, on commence par les mettre en porte à faux. Par une solution de NH₄ OH + H₂ O₂ + H ₂ O, la couche 42 en GaAs n est sous-gravée en 50, sous les couches 43 à 48 qui sont toutes en GaAlAs et ne sont pas attaquées par la solution. L'attaque chimique est limitée par la couche additionnelle 41 en GaAlAs, comme montré en figure 11.

La figure 12 représente une fraction d'une barrette 30 de lasers, comprenant un laser élémentaire dont le ruban 18 est délimité par deux sillons 17 et deux faces 49 non clivées. Ces faces sont en porte à faux sur toute leur longueur en raison de la sous-gravure en 50. Pour pouvoir les micro-cliver, on commence par éliminer, par usinage ionique, les parties repérées 51 à 54 qui sont au dessus de la sous-gravure 50 et à l'extérieur de la région de chaque laser délimitée par les deux sillons 17. Il reste donc, de chaque côté de la barrette 30 pour chaque laser élémentaire une micro-poutre 55 et 56, centrée sur le laser, et en porte à faux. Par ultra-sons, on casse ces micro-poutres 55 et 56, et le laser est alors compris entre deux faces clivées dont les traces sont en 57 et 58, sensiblement à l'aplomb du fond de la sous gravure 50 : l'alignement des faces clivées en 57 et 58 constitue la face latérale 34 (fig. 6).

L'aspect d'une face latérale 34 de barrette 30 de lasers est mieux détaillé en figure 13, qui complète la figure 6, plus générale.

L'opération finale consiste à déposer des métallisations de contacts électriques en 32 sur les barrettes 30 de lasers et en 33 sur les réglettes 28 de réflecteurs. Il est avantageux de déposer simultanément une couche d'or sur les flancs 29 des réflecteurs, pour en améliorer le pouvoir réflecteur.

L'alimentation électrique d'un laser se fait donc depuis la métallisation 32, à travers les couches conductrices 48 à 42, avec retour à la métallisation 33 par l'intermédiaire des couches 41 et 40 qu'on a volontairement épargnées sur les flancs 29 des réflecteurs et dans l'espace 31.

Il a été dit précédemment que l'alimentation des lasers élémentaires peut se faire à travers le substrat conducteur : tous les lasers sont alors en parallèles, et il faut leur fournir une énergie de 2V sous 500A si le circuit intégré a une puissance optique de 1kW. Il est plus intéressant de les alimenter en série-parallèle, avec la structure qui a été décrite. Si par exemple le circuit intégré comporte 33 barrettes de 30 lasers chacune, ces 33 barrettes sont alimentées en série, ce qui permet d'appliquer une tension de 66 V. Dans chaque barrette, les 30 lasers élémentaires sont alimentés en parallèle : il faut 15 ampères. On sait mieux réguler 15 A sous 66 V que 500 A sous 2 V, et cela simplifie, les jonctions métalliques d'alimentation.

Dans ce cas, les métallisations en surface du circuit intégré ont la configuration représentée en figure 14.

Chaque métallisation 33 sur un réflecteur 28 est réunie par une ou deux métallisations 59-60 à la métallisation 32 de la barrette 30 qui lui est voisine. Le courant suit les flêches brisées indiquées sur la figure. Sortant d'une barrette 30, il emprunte les couches 40 et 41 pour reboucler avec la métallisation 33 d'un réflecteur, d'où il est réinjecté dans la barrette suivante, par les conducteurs 59 et 60. L'alimentation série-parallèle suppose que le substrat est semi-isolant.

Le circuit intégré de puissance selon l'invention est utilisé soit seul, comme laser semiconducteur de puissance, soit associé à un laser solide. L'énergie produite est comprise, selon le nombre de circuits associés, entre 1kW optique pour un circuit intégré seul, et quelques dizaines de kW pour plusieurs circuits associés. L'énergie est pulsée pendant quelques dizaines de nanosecondes, à une fréquence de quelques dizaines de Hertz. Il est utilisé en chirurgie, en découpe de matériaux ou en soudure .

## Revendications

1. Dispositif optoélectronique de puissance, émetteur de lumière cohérente fournie par une pluralité de lasers élémentaires associés en barrettes de lasers (30), constitué par un circuit intégré, supporté par un substrat (27) en matériaux semiconducteurs de la famille III-V, et comportant :
- au moins une barrette (30) à flancs latéraux longitudinaux parallèles (34) formée par épitaxie sur le substrat (27) d'une pluralité de couches (40 à 48) constitutives des lasers élémentaires, dont les rubans émissifs (18) sont parallèles entre eux et perpendiculaires aux flancs longitudinaux (34) de la barrette (30)
- au moins une réglette réflectrice (28), parallèle à la barrette (30) de lasers, ledit circuit intégré étant complété par au moins une première métallisation (32), déposée sur la barrette (30) de lasers, et une seconde métallisation (33), pour l'alimentation électrique des lasers formés dans la barrette (30),
ce dispositif étant caractérisé en ce que lesdits flancs latéraux longitudinaux (34) sont micro-clivés (en 57,58), de sorte que chaque ruban émissif (18) produit deux faisceaux (35,36) ces faisceaux étant parallèles au plan du substrat (27), et en ce que ladite réglette est gravée en relief dans le substrat (27), et d'épaisseur au moins égale à celle de la barrette (30), de façon que les flancs (29) métallisés de la réglette (28), inclinés par rapport au plan du substrat (27), constituent des réflecteurs qui renvoient les faisceaux (35, 36) émis par les rubans (18) sensiblement perpendiculairement par rapport au plan du substrat (27).

2. Dispositif selon la revendication 1, caractérisé en ce que les lasers élémentaires sont de type à puits quantique, à guidage par l'indice, la barrette (30) étant gravée, pour chaque laser élémentaire, par deux sillons (17) qui définissent le ruban émissif (18), et sont perpendiculaires aux flancs longitudinaux (34) de la barrette (30) de lasers.

3. Dispositif selon la revendication 1, caractérisé en ce que la réglette de réflecteurs (28) a, perpendiculairement à son axe longitudinal, une section en trapèze, dont les flancs (29) sont inclinés à 45° par rapport au plan du substrat (27), lesdits flancs étant métallisés pour augmenter le pouvoir réflecteur.

4. Dispositif selon la revendication 1, caractérisé en ce que la réglette de réflecteurs (28) a, perpendiculairement à son axe longitudinal, une section sensiblement semi-circulaire (39), la surface semi-cylindrique ainsi formée étant métallisée pour augmenter le pouvoir réflecteur.

5. Dispositif selon l'une quelconque des revendications 1 à 4, caractérisé en ce que, si le substrat (27) est en matériaux semi-isolants, il est alimenté en série-parallèle, tous les lasers élémentaires d'une même barrette (30) étant alimentés en parallèle, et toutes les barrettes d'un circuit intégré étant alimentées en série, la métallisation (32) déposée sur une barrette de lasers (30) étant réunie par au moins un conducteur (59, 60) à la métallisation (33) déposée sur une réglette de réflecteurs (28) voisine de ladite barrette de lasers (30), l'alimentation électrique étant appliquée entre la première et la dernière métallisations de la série sur le circuit intégré.

6. Dispositif selon l'une quelconque des revendications 1 à 4, caractérisé en ce que, si le substrat (27) est en matériaux conducteurs, tous les lasers élémentaires du circuit intégré sont alimentés en parallèle, toutes les métallisations (32) déposées sur les barrettes de lasers (30) étant réunies à une première borne de l'alimentation, et toutes les métallisations (33) déposées sur les réglettes de réflecteurs (28) étant réunies à une deuxième borne de l'alimentation.

7. Dispositif optoélectronique de puissance, émetteur de lumière cohérente, caractérisé en ce qu'il comporte au moins un circuit intégré (22) de lasers selon la revendication 1, appliqué contre une face principale d'un laser solide (21) en forme de plaque, ledit circuit intégré (22), régulé en température par une semelle métallique (23) et un module à effet Peltier (24), et régulé en courant par une diode de régulation (25), excitant le laser solide (21) qui émet, par une face latérale (26) un faisceau de forte puissance de lumière cohérente, pulsée.

8. Procédé de réalisation d'un dispositif optoélectronique de puissance selon l'une quelconque des revendications 1 à 6, caractérisé en ce qu'il comporte les étapes suivantes :
a) à partir d'un substrat (27) en matériaux semiconducteurs du groupe III-V, gravure par usinage ionique des réglettes de réflecteurs (28), avec une section dont les flancs (29) sont inclinés à 45° ou une section semi-cylindrique (39),
b) sur la surface libre du substrat (27) et des réglettes de réflecteurs (28), dépôt par épitaxie :
- d'une première couche (40), épaisse, conductrice, en un premier type de matériau adapté à celui du substrat (27),
- d'une deuxième couche (41), à dopage graduel, en un second type de matériau non attaquable par une solution chimique qui attaque le premier type de matériau,
- d'une troisième couche (42), en un premier type de matériau,
- d'une pluralité de couches (43 à 48) constitutives de la structure d'un laser, toutes ces couches étant en un matériau du second type, non attaquable par ladite solution chimique,
c) gravure, dans les couches épitaxiées, de sillons (17) qui délimitent, pour chaque laser élémentaire, le ruban émissif (18), par guidage par l'indice,
d) décapage, par usinage ionique, des couches épitaxiées sauf les deux premières déposées (40,41), de façon à isoler les barrettes de lasers (30),
e) sous-gravure, par une solution de NH₄OH + H₂O₂ + H₂O, de la troisième couche (42), en matériau attaquable par ladite solution, tandis que la deuxième couche (41), en matériau non attaquable par ladite solution, constitue une barrière d'arrêt à la sous-gravure, laquelle met en porte à faux (50) les faces longitudinales (49) des barrettes de lasers (30).
f) élimination, par usinage ionique, des parties (51 à 54) des barrettes de lasers (30) qui sont en porte à faux et situées à l'extérieur de la région de chaque laser élémentaire délimitée par deux sillons (17),
g) clivage par ultra-sons des parties (55,56) de chaque laser élémentaire subsistantes en porte à faux après l'étape précédente, de façon à doter chaque laser de deux faces clivées (57,58),
h) dépôt des métallisations de contacts électriques, dont une métallisation (32) sur chaque barrette de lasers (30) et une métallisation (33) sur chaque réglette de réflecteurs (28), les flancs (29) des dits réflecteurs (28) étant également métallisés pour accroître leur pouvoir réflecteur.

9. Dispositif selon la revendication 8, caractérisé en ce que, parmi la pluralité de couches (40 à 48) épitaxiées sur le substrat (27), la première (40) et la troisième (42) couches, à partir du substrat (27), sont en un premier type de matériau attaquable par une solution chimique, toutes les autres couches (41,43-48) étant en un second type de matériau non attaquable par ladite solution chimique.

10. Dispositif selon la revendication 9, caractérisé en ce que la première (40) et la deuxième (41) couches épitaxiées sont épaisses (2-5 »m) et recouvrent l'espace (31) situé entre une barrette de lasers (30) et une réglette de réflecteurs (28) ainsi que la réglette (28) elle-même, lesdites première et deuxième couches (40,41) constituant un conducteur électrique sur lequel est déposée la deuxième métallisation (33) de prise de contact, sur la réglette de réflecteurs (28).

## Patentansprüche

1. Optoelektronische Vorrichtung hoher Ausgangsleistung, die kohärentes Licht abgibt, das von mehreren Elementarlasern geliefert wird, die in Laserstegen (30) vereinigt sind, wobei die Vorrichtung durch eine integrierte Schaltung gebildet ist, die von einem Substrat (27) aus Halbleitermaterialien der Gruppe III-V getragen ist, enthaltend:
- wenigstens einen Steg (30) mit parallelen seitlichen Längsflanken (34), der durch Aufwachsen mehrerer die Elementarlaser bildender Schichten (40 bis 48) auf dem Substrat (27) gebildet ist, wobei die emittierenden Streifen (18) der Elementarlaser zueinander parallel und zu den Längsflanken (34) des Steges (30) senkrecht sind,
- wenigstens eine zu dem Lasersteg (30) parallele Reflektorleiste (28),
wobei die integrierte Schaltung durch wenigstens eine erste, auf den Lasersteg (30) aufgebrachte Metallisierung (32) und eine zweite Metallisierung (33) für die Stromversorgung der auf dem Steg (30) gebildeten Laser ergänzt ist, und wobei diese Vorrichtung dadurch gekennzeichnet ist, daß die seitlichen Längsflanken (34) so mikrogespaltet (in 57, 58) sind, daß jeder emittierende Streifen (18) zwei Strahlenbündel (35, 36) erzeugt, die zur Ebene des Substrats (27) parallel sind, und daß diese Leiste reliefartig in das Substrat (27) geätzt ist und eine Dicke besitzt, die zumindest gleich der des Steges (30) ist, so daß die metallisierten, gegenüber der Ebene des Substrats (27) geneigten Flanken (29) der Leiste (28) Reflektoren bilden, die die von den Streifen (18) abgegebenen Strahlenbündel (35, 36) im wesentlichen senkrecht zu der Ebene des Substrats (27) zurückwerfen.

2. Vorrichtung nach Anspruch 1, dadurch gekennzeichnet, daß die Elementarlaser vom Quantentopf-Typ mit Indexführung sind, wobei für jeden Elementarlaser zwei Rillen (17) in den Steg (30) geätzt sind, die den emittierenden Streifen (18) definieren und zu den Längsflanken (34) des Lasersteges (30) senkrecht sind.

3. Vorrichtung nach Anspruch 1, dadurch gekennzeichnet, daß die Reflektorleiste (28) senkrecht zu ihrer Längsachse einen trapezförmigen Querschnitt besitzt, dessen Flanken (29) gegenüber der Ebene des Substrats (27) um 45° geneigt sind, wobei die Flanken metallisiert sind, um das Reflexionsvermögen zu verbessern.

4. Vorrichtung nach Anspruch 1, dadurch gekennzeichnet, daß die Reflektorleiste (28) senkrecht zu ihrer Längsachse einen im wesentlichen halbkreisförmigen Querschnitt (39) besitzt, wobei die so gebildete halbzylindrische Oberfläche metallisiert ist, um das Reflexionsvermögen zu verbessern.

5. Vorrichtung nach einem der Ansprüche 1 bis 4, dadurch gekennzeichnet, daß sie dann, wenn das Substrat (27) aus halbisolierenden Materialien besteht, serien-parallel gespeist wird, wobei sämtliche Elementarlaser eines gleichen Steges (30) parallel und sämtliche Stege einer integrierten Schaltung seriell gespeist werden, wobei die auf einen Lasersteg (30) aufgebrachte Metallisierung (32) über wenigstens einen Leiter (59, 60) mit der Metallisierung (33) verbunden ist, die auf eine dem Lasersteg (30) benachbarte Reflektorleiste (28) aufgebracht ist, und wobei die Stromversorgung zwischen die erste und die zweite Metallisierung der Serienanordnung auf der integrierten Schaltung angelegt wird.

6. Vorrichtung nach einem der Ansprüche 1 bis 4, dadurch gekennzeichnet, daß dann, wenn das Substrat (27) aus Leitermaterialien besteht, sämtliche Elementarlaser der integrierten Schaltung parallel gespeist werden, wobei sämtliche auf den Laserstegen (30) aufgebrachte Metallisierungen (32) mit einer ersten Anschlußklemme und sämtliche auf den Reflektorleisten (28) aufgebrachte Metallisierungen (33) mit einer zweiten Anschlußklemme verbunden sind.

7. Optoelektronische Vorrichtung hoher Ausgangsleistung, die kohärentes Licht abgibt, dadurch gekennzeichnet, daß sie wenigstens eine integrierte Laserschaltung (22) nach Anspruch 1 enthält, die an eine Hauptseite eines plattenförmigen Festkörperlasers (21) angelegt ist, wobei die integrierte Schaltung (22), die durch eine Metallunterlage (23) und ein Modul (24) mit Peltiereffekt temperaturstabilisiert und durch eine Stabilisierungsdiode (25) stromstabilisiert ist, den Festlaser (21) anregt, der über eine Seitenfläche (26) ein Strahlenbündel gepulsten kohärenten Lichtes hoher Leistung abgibt.

8. Verfahren zur Herstellung einer optoelektronischen Vorrichtung hoher Ausgangsleistung gemäß einem der Ansprüche 1 bis 6, dadurch gekennzeichnet, daß es die folgenden Schritte enthält:
a) ausgehend von einem Substrat (27) aus Halbleitermaterialien der Gruppe III-V durch Ionenbehandlung erfolgendes Ätzen der Reflektorleisten (28) mit einem Querschnitt, dessen Flanken (29) um 45° geneigt sind, oder einem halbzylindrischen Querschnitt (39),
b) auf der freien Oberfläche des Substrats (27) und der Reflektorleisten (28) durch Epitaxie erfolgendes Aufbringen von:
- einer ersten dicken, leitenden Schicht (40) aus einem ersten Materialtyp, der an den des Substrats (27) angepaßt ist,
- einer zweiten Schicht (41) mit abgestufter Dotierung aus einem zweiten Materialtyp, der durch eine den ersten Materialtyp ätzende chemische Lösung nicht ätzbar ist,
- einer dritten Schicht (42) aus einem ersten Materialtyp,
- mehreren die Struktur eines Lasers bildenden Schichten (43 bis 48), die alle aus einem Material des zweiten, durch die chemische Lösung nicht ätzbaren Typs bestehen,
c) Ätzen von Rillen (17) in die Epitaxieschichten, welche Rillen für jeden Elementarlaser den emittierenden Streifen (18) durch Indexführung begrenzen,
d) durch Ionenbehandlung erfolgendes Anätzen der Epitaxieschichten außer den beiden zuerst aufgebrachten (40, 41), um die Laserstege (30) zu isolieren,
e) durch eine Lösung von NH₄OH + H₂O₂ + H₂O erfolgendes Unterätzen der dritten Schicht (42) aus durch die Lösung ätzbarem Material, während die zweite Schicht (41) aus nicht durch die Lösung ätzbarem Material eine Barriere für die Unterätzung bildet, die die Längsseiten (49) der Laserstege (30) überhängend macht,
f) durch Ionenbehandlung erfolgendes Entfernen der Teile (51 bis 54) der Laserstege (30), die überhängen und außerhalb des Bereichs eines jeweiligen Elementarlasers angeordnet sind, der durch die beiden Rillen (17) begrenzt ist,
g) durch Ultraschall erfolgendes Spalten der noch vorhandenen überhängenden Teile (55, 56) eines jeweiligen Elementarlasers nach dem vorhergehenden Schritt, um jeden Laser mit zwei gespaltenen Seiten (57, 58) zu versehen, und
h) Aufbringen von Metallisierungen für elektrische Kontakte, davon eine Metallisierung (32) auf jedem Lasersteg (30) und eine Metallisierung (33) auf jeder Reflektorleiste (28), wobei auch die Flanken (29) der Reflektoren (28) metallisiert werden, um deren Reflexionvermögen zu verbessern.

9. Vorrichtung nach Anspruch 8, dadurch gekennzeichnet, daß von der Mehrzahl von Epitaxieschichten (40 bis 48) auf dem Substrat (27) ausgehend von dem Substrat (27) die erste Schicht (40) und die dritte Schicht (42) aus einem ersten Materialtyp bestehen, der durch eine chemische Lösung ätzbar ist, während alle anderen Schichten (41, 43-48) aus einem zweiten Materialtyp bestehen, der durch die chemische Lösung nicht ätzbar ist.

10. Vorrichtung nach Anspruch 9, dadurch gekennzeichnet, daß die erste Epitaxieschicht (40) und die zweite Epitaxieschicht (41) verstärkt (2-5 »m) sind und den Raum (31) zwischen einem Lasersteg (30) und einer Reflektorleiste (28) sowie die Leiste (28) selbst bedecken, wobei die erste Schicht (40) und die zweite Schicht (41) einen elektrischen Leiter bilden, auf dem die zweite Kontaktierungsmetallisierung (33) auf der Reflektorleiste (28) aufgebracht ist.

## Claims

1. Optoelectronic power device which is an emitter of coherent light delivered by a plurality of elementary lasers combined in linear arrays of lasers (30), this device being constituted by an integrated circuit supported by a substrate (27) made of group III-V semiconductor materials and comprising:
- at least one linear array (30) with parallel longitudinal lateral flanks (34) formed by epitaxial growth, on the substrate (27), of a plurality of layers (40 to 48) constituting the elementary lasers, the emitting stripes (18) of which are mutually parallel and perpendicular to the longitudinal flanks (34) of the linear array (30),
- at least one reflector strip (28) parallel to the linear array (30) of lasers,
the said integrated circuit being completed by at least a first metallization (32), deposited on the linear array (30) of lasers, and a second metallization (33), for the electrical supply of the lasers formed in the linear array (30), this device being characterized in that the said longitudinal lateral flanks (34) are microcleaved (at 57, 58), so that each emitting strip (18) produces two beams (35, 36), these beams being parallel to the plane of the substrate (27), and in that the said strip is etched in relief in the substrate (27) and has a thickness at least equal to that of the linear array (30), so that the metallized flanks (29) of the strip (28), which are inclined with respect to the plane of the substrate (27), constitute reflectors which reflect the beams (35, 36) emitted by the stripes (18) substantially perpendicularly with respect to the plane of the substrate (27).

2. Device according to Claim 1, characterized in that the elementary lasers are of the index-guided quantum-well type, the linear array (30) being etched, for each elementary laser, by two grooves (17) which define the emitting strip (18) and are perpendicular to the longitudinal flanks (34) of the linear array (30) of lasers.

3. Device according to Claim 1, characterized in that the strip of reflectors (28) has, perpendicular to its longitudinal axis, a trapezoidal cross-section, the longitudinal flanks (29) of which are inclined at 45° with respect to the plane of the substrate (27), the said flanks being metallized to increase the reflectivity.

4. Device according to Claim 1, characterized in that the strip of reflectors (28) has, perpendicular to its longitudinal axis, a substantially semicircular cross-section (39), the semicylindrical surface thus formed being metallized to increase the reflectivity.

5. Device according to any one of Claims 1 to 4, characterized in that, if the substrate (27) is made of semi-insulating materials, it is series/parallel supplied, all the elementary lasers of the same linear array (30) being parallel supplied and all the linear arrays of an integrated circuit being series supplied, the metallization (32) deposited on a linar array of lasers (30) being joined by at least one conductor (59,60) to the metallization (33) deposited on a strip of reflectors (28) neighbouring the said linear array of lasers (30), the electrical supply being applied between the first and last metallizations of the series on the integrated circuit.

6. Device according to any one of Claims 1 to 4, characterized in that, if the substrate (27) is made of conducting materials, all the elementary lasers of the integrated circuit are parallel supplied, all the metallizations (32) deposited on the linear arrays of lasers (30) being joined to a first supply terminal and all the metallizations (33) deposited on the strips of reflectors (28) being joined to a second supply terminal.

7. Optoelectronic power device, which is an emitter of coherent light, characterized in that comprises at least one integrated circuit (22) of lasers according to Claim 1, applied against a main face of a solid-state laser (21) in the form of a wafer, the said integrated circuit (22), temperature-regulated by a metallic base-plate (23) and a Peltier-effect module (24) and current-regulated by a regulating diode (25), exciting the solid-state laser (21) which emits a high-power beam of pulsed coherent light from a lateral face (26).

8. Method of fabricating an optoelectronic power device according to any one of Claims 1 to 6, characterized in that it comprises the following steps:
a) starting from a substrate (27) made of group III-V semiconductor materials, etching, by ion machining, the strips of reflectors (28), with a cross-section of which the flanks (29) are inclined at 45°, or with a semi-cylindrical cross-section (39),
b) depositing by epitaxy, on the free surface of the substrate (27) and of the reflector strips (28):
- a first, conducting, thick layer (40) made of a first type of material matched to that of the substrate (27),
- a second layer (41), with gradual doping, made of a second type of material which cannot be attacked by a chemical solution which does attack the first type of material,
- a third layer (42), made of a first type of material and
- a plurality of layers (43 to 48) constituting the structure of a laser, all these layers being made of a material of the second type, which cannot be attacked by the said chemical solution;
c) etching, in the epitaxially grown layers, grooves (17) which demarkate, for each elementary laser, the index-guiding emissive stripe (18);
d) removing, by ion machining, the epitaxially grown layers except for the first two layers (40, 41), so as to isolate the linear arrays of lasers (30);
e) underetching, using a solution of NH₄OH + H₂O₂ + H₂O, the third layer (42), made of a material capable of being attacked by the said solution, while the second layer (41), made of a material which cannot be attacked by the said solution, constitutes an underetching stop barrier, which places the longitudinal faces (49) of the linear arrays of lasers (30) in an overhanging position (50);
f) removing, by ion machining, the parts (51 to 54) of the linear arrays of lasers (30) which are overhanging and are located outside that region of each elementary laser demarkated by two grooves (17);
g) cleaving, by ultrasound, the parts (55, 56) of each elementary laser which remain overhanging after the previous step, so as to provide each laser with two cleaved faces (57, 58);
h) depositing the electrical contact metallizations, including a metallization (32) on each linear array of lasers (30) and a metallization (33) on each strip of reflectors (28), the flanks (29) of the said reflectors (28) also being metallized to increase their reflectivity.

9. Device according to Claim 8, characterized in that, among the plurality of layers (40 to 48) epitaxially grown on the substrate (27), the first (40) and third (42) layers, starting from the substrate (27), are made of a first type of material which can be attacked by a chemical solution, all the other layers (41, 43-48) being made of a second type of material which cannot be attacked by the said chemical solution.

10. Device according to Claim 9, characterized in that the first (40) and second (41) epitaxially grown layers are thick (2-5 »m) and cover the space (31) located between a linear array of lasers (30) and a strip of reflectors (28), as well the strip (28) itself, the said first and second layers (40, 41) constituting an electric conductor, onto which the second contact-making metallization (33) is deposited, on the strip of reflectors (28).
